# EUROPEAN PATENT APPLICATION

(11) **EP 3 823 020 A1**
(43) Date of publication of application: **19.05.2021**
(21) Application number: 19208940.7
(22) Date of filing: 13.11.2019
(51) Int. Cl.: H01L 23/495

(54) **A LEAD FRAME ASSEMBLY FOR A SEMICONDUCTOR DEVICE**

(71) Applicant: Nexperia B.V., 6534 AB Nijmegen (NL)
(72) Inventor: Fenol, Florante, 6534 AB Nijmegen (NL); Yandoc, Ricardo, 6534 AB Nijmegen (NL)
(74) Representative: Pjanovic, Ilija

(57) **Abstract**

This disclosure relates to a lead frame assembly for a semiconductor device, the lead frame assembly comprising: a lead portion including a connection member having a first contact portion, wherein the first contact portion comprises a plurality of side walls extending from a top major surface to a bottom major surface and each of said side walls comprises a notch portion formed therein..

## Description

### FIELD

The present disclosure relates to a lead frame assembly for a semiconductor device. In particular, this disclosure relates to an interconnected lead frame assembly for a semiconductor device and a semiconductor device comprising such a lead frame assembly.

### BACKGROUND

Integrating two semiconductor dies into a single packaged semiconductor device can provide a significant reduction in device footprint compared to two separate semiconductor devices. The semiconductor dies may be transistors arranged, for example, in a half bridge configuration.

Where the transistors are field effect transistors for example, in the half-bridge configuration, it is necessary to connect the source of the first MOSFET to the drain of the second field effect transistor using an external connection, usually provided on the carrier or printed circuit board to which the transistor are attached. This connection can create an inductive loop which can slow the switching of the devices.

Two separate transistors devices arranged in a half-bridge can take valuable board space and the connections from source to drain can also cause a large inductive loop and may slow the switching of the devices.

Various half bridge arrangements involve the use of a connection member to electrically connect a source contact of a first semiconductor die to a die pad on which a drain contact of a second semiconductor die is electrically and mechanically mounted. This connection member therefore allows for the connection of the source contact of a first semiconductor die to the drain contact of a second semiconductor die consistent with the half-bridge arrangements. Typically, the connection member are formed of metal or metal alloys and the mechanical and electrical connection of the connection member to the die pad is achieved by a solder material.

However, conventional solder connections may not be robust and may degrade over time due to mechanical stresses brought about thermal cycling during operation of the semiconductor device. Degradation or the solder connection can ultimately result in failure of the semiconductor device.

### SUMMARY

Various example embodiments are directed to issues such as those addressed above and/or others which may become apparent from the following disclosure concerning improving solder connections for semiconductor devices.

In certain example embodiments, aspects of the present disclosure involve the improving thermal and electrical connections for semiconductor devices.

According to an embodiment there is provided a lead frame assembly for a semiconductor device, the lead frame assembly comprising: a lead portion including a connection member having a first contact portion, wherein the first contact portion comprises a plurality of side walls extending from a top major surface to a bottom major surface and each of said side walls comprises a notch portion formed therein.

The notch portion may extend from the top major surface to the bottom major surface into the first contact portion.

The number of notch portions may be equal to the number of side wall portions of the first contact portion.

The bottom major surface may be a contact surface configured and arranged for contacting to a conductive surface.

The lead frame assembly may further comprise a second contact portion at an opposite end of said connection member to said first contact portion.

The notch portion may be configured and arranged for receiving a conductive adhesive and the conductive adhesive may be a solder material.

The surface area of the notch portion may be in the range 0.32mm² to 0.80mm². The notch portions increase the surface area of the first and second contact portions.

According to an embodiment there is also provided semiconductor device comprising such a lead frame.

### DESCRIPTION OF THE DRAWINGS

So that the manner in which the features of the present disclosure can be understood in detail, a more particular description is made with reference to embodiments, some of which are illustrated in the appended figures. It is to be noted, however, that the appended figures illustrate only typical embodiments and are therefore not to be considered limiting of its scope. The figures are for facilitating an understanding of the disclosure and thus are not necessarily drawn to scale. Advantages of the subject matter claimed will become apparent to those skilled in the art upon reading this description in conjunction with the accompanying figures, in which like reference numerals have been used to designate like elements, and in which:
Figure 1a illustrates a lead frame assembly for a semiconductor device according to an embodiment;
Figure 1b illustrates a more detailed view of a contact portion of the lead frame assembly of Figure 1a;
Figure 2a illustrates the lead frame assembly of Figure 1a arranged in a semiconductor device; and
Figure 2b illustrates a more detailed view of the lead frame assembly of Figure 2a.

### DETAILED DESCRIPTION

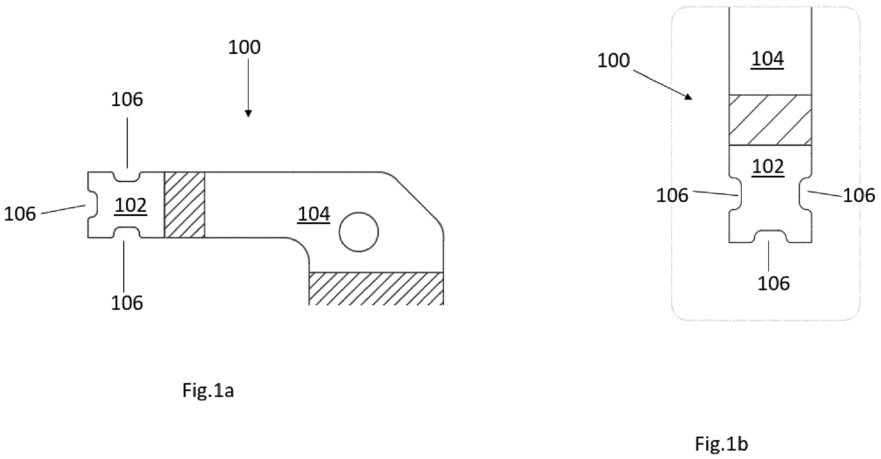

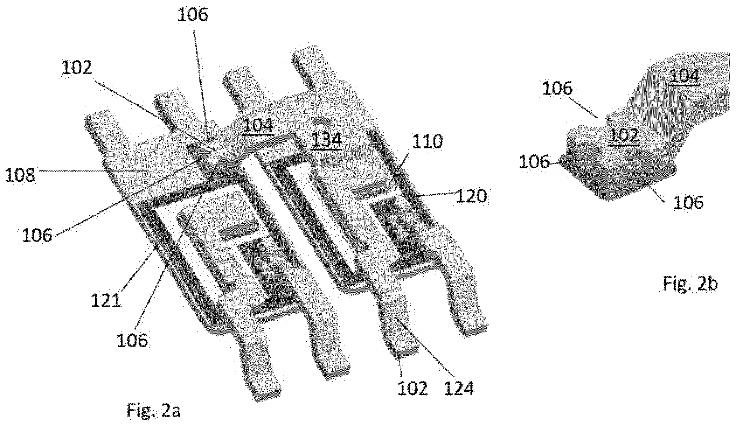

A lead frame assembly 100 for a semiconductor device is illustrated in Figure 1a. The lead frame assembly comprises a contact portion 102 which is suitable for being electrically and mechanically connected to a carrier (not illustrated in Figure 1a) such as a die pad for mounting a semiconductor die thereon or a contact pad of a printed circuit board. The semiconductor die may be a transistor such as a MOSFET. The arrangement of the lead frame assembly 100, carrier and semiconductor die will be discussed in more detail below with respect to Figures 2a and 2b.

The contact portion 102 may be arranged at one end of the connection member 104 where, for example the connection member 104 may be arranged to electrically connect electrical contacts of one or more semiconductor dies to each other or to external leads. In this regard the connection member 104 may form a portion of a lead of a semiconductor device.

Figure 1b illustrates the contact portion 102 of Figure 1a in more detail. The contact portion 102 may comprise a plurality of cut away portions or notches 106 formed in the side walls of the contact portion 102. The notches 106 extend from the sidewalls of the contact portion 102 partially into the contact portion 102 and also extend from a top surface to a bottom surface of the contact portion 102. In other words, the notches 106 have a height equal to the thickness (that is the distance from the top surface to the bottom surface) of the contact portion.

In this way the skilled person will appreciate that notches 106 according to an embodiment formed in the contact portion 102 increase the circumference and thus the surface area of the contact portion 102 when compared to a contact portion without said notches 106. By increasing the surface area of the contact portion 102 in this way, the volume of the adhesive material, such as for example solder or conductive adhesive, which may be bonded to the contact portion 102 can be greater than a contact portion without said notches.

For example, where there are three notches 106 and each of the notches has the dimensions 0.25mm x 0.08mm x 0.2mm formed in the contact portion 102 the surface area increases by 15% when compared to a known contact portion.

This allows for an increase in solder volume of approximately 26% compared to a contact portion with no notches. The notches 106 allow for increased solder area attached to the contact portion 102 and thus improved adhesion between the contact portion 102 and the surface on which the contact portion is mounted. In this way the contact portion 102 provides for robust design with superior adhesion.

In addition, by providing notches 106 in the contact portion 102 it will be easier to view the solder joints and in particular, monitor soldering processes during contacting of the contact portion 102. In particular, it will be easier to monitor whether excessive and or insufficient solder volume has been dispensed because the notches 106 make the solder joint area more visible when compared to a contact portion 102 without such notches 106. Monitoring may be achieved by manual inspection or by automatic optical inspection. Typically, the number of notches 106 will be equal to the number of free sides on the contact portion 102. As illustrated in Figures 1a and 1b the number of free sides is three (the fourth side forming the connection member 104) and as such the number of notches is three. In other words, a notch may be provided in each of the sidewalls of the contact portion 102.

Figure 2a illustrates a specific application of the contact portion 102 comprising notches 106 comprising two interconnected semiconductor dies 120, 121. A connection member 134 may be fixedly attached by a conductive adhesive or solder at a first end to a second carrier 108 by the contact portion 102, comprising notches 106, according to embodiments. The connection member 134 may be fixedly attached at a second end, distal the first end, to the first contact 110 of the first semiconductor die 120 by any appropriate means such as a conductive adhesive or a solder.

A portion of the connection member 134, between the first end, contacting to the second carrier 108, and the second end, contacting the first contact of the first semiconductor die 102, may be higher than the first and second ends. In this regard the connection member 134 may be considered to comprise an intermediate portion that is higher than the respective first and second ends. This ensures that the connection member does not contact any other part of the first and second carriers or first and second dies other than at the first and second ends of the conductive member, as mentioned above.

The conductive member 134 may comprise an optional further lead portion 124 which extends in a direction away from the first contact 110 of the first semiconductor die 102. The optional further lead portion 124 may form an external contact or lead of the semiconductor device 100, suitable for connection to a carrier such as a printed circuit board, by way of the connection to the first semiconductor die 102 by the first contact 110. As discussed above, the optional further lead portion 124 may comprise a contact portion 102, comprising notches 106, according to embodiments.

The conductive member 134 comprising the lead portion 124 may be formed of single piece of conductive material. Alternatively, the conductive member 134 may be joined to the lead portion at any appropriate point, such as for example the first contact 110, by for example soldering, welding or a conductive adhesive. In addition to the electrically functionality described above, the conductive member 134 may also serve to hold the first semiconductor die in position on the first carrier by the application of a downward pressure applied by the carrier to the die. This may prevent the die from tilting or moving during fabrication of the semiconductor device, or from tilting or moving following fabrication. In this regard the contact portion 102 may be used for internal connections within the semiconductor device.

Figure 2b illustrates a more detailed view of a contact portion 102 of the lead frame assembly of Figure 1a. The contact portion 102 may be implemented on a lead end of an external lead 124 for solder connection of the external lead 124 to a carrier such as a PCB. In this regard, the contact portion 102 may be used for external electrical connections to or from the semiconductor device. The external lead 124 may be a so-called gull wing type lead. Likewise, the conductive member 134 may also comprise a gull wing arrangement adjacent to the contact portion 102 attached to the second carrier 108.

The skilled person will see therefore that the contact portion 102 provides for more robust solder or conductive adhesive connections for semiconductor devices. The notches will serve as the anchoring feature for solder by increasing solder fillet volume thus strengthening the connection between the contact portion and the contact surface.

Particular and preferred aspects of the invention are set out in the accompanying independent claims. Combinations of features from the dependent and/or independent claims may be combined as appropriate and not merely as set out in the claims.

The scope of the present disclosure includes any novel feature or combination of features disclosed therein either explicitly or implicitly or any generalisation thereof irrespective of whether or not it relates to the claimed invention or mitigate against any or all of the problems addressed by the present invention. The applicant hereby gives notice that new claims may be formulated to such features during prosecution of this application or of any such further application derived therefrom. In particular, with reference to the appended claims, features from dependent claims may be combined with those of the independent claims and features from respective independent claims may be combined in any appropriate manner and not merely in specific combinations enumerated in the claims.

Features which are described in the context of separate embodiments may also be provided in combination in a single embodiment. Conversely, various features which are, for brevity, described in the context of a single embodiment, may also be provided separately or in any suitable sub combination.

Term "comprising" does not exclude other elements or steps, the term "a" or "an" does not exclude a plurality. Reference signs in the claims shall not be construed as limiting the scope of the claims.

## Claims

1. A lead frame assembly for a semiconductor device, the lead frame assembly comprising:
a lead portion including a connection member having a first contact portion, wherein the first contact portion comprises a plurality of side walls extending from a top major surface to a bottom major surface and each of said side walls comprises a notch portion formed therein.

2. The lead frame assembly of claim 1, wherein the notch portion extends from the top major surface to the bottom major surface into the first contact portion.

3. The lead frame assembly of claims 1 to 2, wherein the number of notch portions is equal to the number of side wall portions of the first contact portion.

4. The lead frame assembly of claims 1 to 3, wherein the bottom major surface is a contact surface configured and arranged for contacting to a conductive surface.

5. The lead frame assembly of claims 1 to 4, further comprising a second contact portion at an opposite end of said connection member to said first contact portion.

6. The lead frame assembly of claims 1 to 4, wherein the notch portion is configured and arranged for receiving a conductive adhesive.

7. The lead frame assembly of claim 6, wherein the conductive adhesive is a solder material.

8. The lead frame assembly of claims 1 to 7, wherein the surface area of the notch portion is in the range 0.32mm² to 0.80mm².

9. The lead frame assembly of claims 1 to 8, wherein the notch portions increase the surface area of the first and second contact portions.

10. A semiconductor device comprising the lead frame assembly of claims 1 to 11.
